(19) **Europäisches Patentamt**

**European Patent Office**

**Office européen des brevets**

(11) **EP 1 172 698 B1**

(12) **EUROPEAN PATENT SPECIFICATION**

(45) Date of publication and mention
of the grant of the patent:
**08.02.2006 Bulletin 2006/06**

(51) Int Cl.:
***G03F 7/20*** (2006.01)

(21) Application number: **01305863.1**

(22) Date of filing: **06.07.2001**

(54) **Lithographic projection apparatus, device manufacturing method, device manufactured thereby and gas composition**

Lithographischer Projektionsapparat, Verfahren zur Herstellung eines Artikel, dabei erzeugter Artikel und Gaszusammensetzung

Appareil de projection lithographique, procédé pour la production d'un dispositif, dispositif produit par ce procédé et composition gazeuse

(84) Designated Contracting States:
**DE FR GB IT NL**

(30) Priority: **14.07.2000 EP 00306022**
**13.06.2001 US 297432 P**

(43) Date of publication of application:
**16.01.2002 Bulletin 2002/03**

(73) Proprietor: **ASML Netherlands B.V.**
**5504 DR Veldhoven (NL)**

(72) Inventors:
• **Pril, Wouter Onno**
**5622 CX Eindhoven (NL)**
• **Henshaw, Philip Dennis**
**Carlisle,**
**Massachusetts 01741 (US)**
• **Van De Pasch, Engelbertus Antonius Franciscus**
**5688 RH Oirschot (NL)**
• **Beems, Marcel Hendrikus Maria**
**5508 EK Veldhoven (NL)**

(74) Representative: **Leeming, John Gerard**
**J.A. Kemp & Co.,**
**14 South Square,**
**Gray's Inn**
**London WC1R 5LX (GB)**

(56) References cited:
**EP-A- 1 098 225      EP-A- 1 122 609**
**EP-A- 1 229 573      WO-A-98/08047**
**US-A- 5 404 222**

• **A. ISHIDA: "Two-Wavelength Displacement-Measuring Interferometer Using Second-Harmonic Light to Eliminate Air-Turbulence-Induced Errors" JAP. JOURNAL OF APPL. PHYSICS/PART 2, vol. 28, no. 3, March 1989 (1989-03), pages 473-475, XP000032562**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

**Description**

The present invention relates to a lithographic projection apparatus comprising:

- a radiation system for supplying a projection beam of radiation;
- patterning means, for patterning the projection beam according to a desired pattern;
- a substrate table for holding a substrate; and
- a projection system for imaging the patterned beam onto a target portion of the substrate.

The term "patterning means" should be broadly interpreted as referring to means that can be used to endow an incoming radiation beam with a patterned cross-section, corresponding to a pattern that is to be created in a target portion of the substrate; the term "light valve" has also been used in this context. Generally, the said pattern will correspond to a particular functional layer in a device being created in the target portion, such as an integrated circuit or other device (see below). Examples of such patterning means include:

- A mask table for holding a mask. The concept of a mask is well known in lithography, and its includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. The mask table ensures that the mask can be held at a desired position in the incoming radiation beam, and that it can be moved relative to the beam if so desired.
- A programmable mirror array. An example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. The required matrix addressing can be performed using suitable electronic means. More information on such mirror arrays can be gleaned, for example, from United States Patents US 5,296,891 and US 5,523,193, which are incorporated herein by reference.
- A programmable LCD array. An example of such a construction is given in UnitedStates Patent US 5,229,872, which is incorporated herein by reference.

For purposes of simplicity, the rest of this text may, at certain locations, specifically direct itself to examples involving a mask table and mask; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (*e.g.* comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus - commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Twin stage lithographic apparatus are described, for example, in US 5,969,441 and WO 98/40791, incorporated herein by reference.

To reduce the size of features that can be imaged, it is desirable to reduce the wavelength of the illumination radiation. Wavelengths of less than 180nm are therefore employed, for example 157nm or 126nm. However, such wavelengths are strongly absorbed by normal atmospheric air leading to unacceptable loss of intensity as the beam traverses the apparatus. In order to solve this problem, it has previously been proposed to flush the apparatus with a flow of gas, the gas being substantially transparent to the illumination wavelength, e.g. nitrogen ($N_2$).

Lithographic projection apparatus may comprise interferometric displacement measuring means, which are used to accurately determine the position of movable tables, such as mask or substrate tables. These means measure the optical path length (geometrical distance x refractive index) to the movable tables using measurement beams of coherent monochromatic radiation. The measuring means are very sensitive to variations in pressure and temperature and in the composition of the medium that the measurement beams traverse through. All three of these variables affect the refractive index of the medium. Typically, in order to account for the variations in refractive index caused by temperature and pressure fluctuations, a second harmonic interferometric device is used. More information with regard to such second harmonic interferometric devices which are capable of compensating for temperature and pressure fluctuations, can be found, for example, in US 5,404,222, which is incorporated herein by reference.

The second harmonic interferometer can, alternatively, compensate for variations in the composition of the medium. However, this second interferometric device cannot simultaneously account for the variations in pressure and temperature and in the composition of the medium.

Some spaces of the projection apparatus may be flushed with a purge gas in order to remove any gas, such as oxygen or water, which absorbs radiation at the wavelength of the projection beam of radiation. The inventors have found that if the gas used to purge the system enters the area where the interferometric displacement measuring means operate, the refractive index in these areas changes and the position measurements are affected. In order to keep the measuring means operating to the high degree of accuracy that is required, any variation from the refractive index of said medium must be avoided.

It is an object of the invention to provide a lithographic projection apparatus in which escapage of the purge gas does not influence the interferometric displacement measuring means.

This and other objects are achieved according to the invention in a lithography apparatus as specified in the opening paragraph, characterized by:

- an interferometric displacement measuring means operating at a wavelength $\lambda_1$ for measuring the position of said substrate table or the position of a table which is a part of said patterning means;
  flushing gas means for supplying purge gas to a space, to displace therefrom ambient air, said space accommodating at least a part of said substrate table and/or at least a part of said table which is a part of said patterning means, wherein said purge gas is substantially non-absorbent of said projection beam of radiation and has a refractive index at a wavelength $\lambda_1$ which is substantially the same as that of air when measured at the same wavelength, temperature and pressure; and
- gas supply means comprising said purge gas.

The inventors have found that by flushing, for example, the mask and substrate stages, which typically comprise movable mask and substrate tables respectively, with a specific gaseous composition having a refractive index identical to that of air under the same measuring conditions, the interferometric displacement measuring means are able to operate to the required degree of accuracy, whilst permitting the use of radiation having a wavelength of 180nm or less.

According to a further embodiment of the invention, there is provided an apparatus as specified above, which comprises a second harmonic interferometric measuring means operating at wavelengths $\lambda_2$ and $\lambda_3$ for adjusting the measurements of said interferometric displacement measuring means to substantially eliminate the effects of variation in pressure and temperature, and

wherein said purge gas comprises three or more different components, each component having refractivities at the wavelengths $\lambda_2$ and $\lambda_3$ such that the following equations are substantially fulfilled:

$$\sum_{j}^{k} F_j \alpha_{j1} = \alpha_{a1} \qquad (1)$$

$$\sum_{j}^{k} F_j (\alpha_{j3} - \alpha_{j2}) = \alpha_{a3} - \alpha_{a2} \qquad (2)$$

wherein $F_j$ is the fraction by volume of component j in the purge gas, which purge gas contains a total of k components, $\alpha_{j1}$ is the refractivity of component j at a wavelength $\lambda_1$, $\alpha_{j2}$ is the refractivity of component j at a wavelength $\lambda_2$, $\alpha_{j3}$ is the refractivity of component j at a wavelength $\lambda_3$, $\alpha_{a1}$ is the refractivity of air at a wavelength $\lambda_1$, $\alpha_{a2}$ is the refractivity of air at a wavelength $\lambda_2$ and $\alpha_{a3}$ is the refractivity of air at a wavelength $\lambda_3$; and wherein:

$$\sum_{j}^{k} F_j = 1. \qquad (3)$$

Where a second harmonic interferometer is present in the apparatus, the simple adjustment of the refractive index of the purge gas to that of air at the wavelength of operation of the displacement measuring interferometer, is not sufficient to overcome the errors in the displacement measurement caused by purge gas leakage. The present inventors have therefore devised a purge gas composition which comprises at least three different components, each component typically having significantly differing refractivities (wherein the refractivity is defined as the refractive index-1). With proper choice of gases, such that the gases fulfil, or substantially fulfil the equations given above, the compositional variation of the purge gas will have no, or substantially no effect on the measurements of either interferometer. Thus accurate positional measurements, which take into account variations in temperature, pressure and leakage of purge gas, may be obtained.

According to a further aspect of the invention there is provided a lithographic apparatus as specified in the opening paragraph which is characterized by:

- an interferometric displacement measuring means operating at a wavelength $\lambda_1$ for measuring the position of said substrate table or the position of a table which is a part of said patterning means;
- a second harmonic interferometric measuring means operating at wavelengths $\lambda_2$ and $\lambda_3$ for adjusting the measurements of the said interferometric displacement measuring means to substantially eliminate the effects of variation in pressure and temperature;
- flushing gas means for supplying purge gas to a space, to displace therefrom ambient air, said space accommodating at least a part of said substrate table and/or at least a part of said table which is a part of said patterning means, wherein said purge gas is substantially non-absorbent of said projection beam of radiation and comprises two or more components, each component having refractivities at the wavelengths $\lambda_1$, $\lambda_2$ and $\lambda_3$ such that the following equation is substantially fulfilled:

$$\frac{\alpha_{m1}}{(\alpha_{m3} - \alpha_{m2})} = K_a \qquad (4)$$

wherein $\alpha_{m1}$ is the refractivity of the purge gas at a wavelength $\lambda_1$, $\alpha_{m2}$ is the refractivity of the purge gas at a wavelength $\lambda_2$, $\alpha_{m3}$ is the refractivity of the purge gas at a wavelength $\lambda_3$ and

$$K_a = \frac{\alpha_{a1}}{(\alpha_{a3} - \alpha_{a2})} \qquad (5)$$

wherein $\alpha_{a1}$ is the refractivity of air at a wavelength $\lambda_1$, $\alpha_{a2}$ is the reefractivity of air at a wavelength $\lambda_2$ and $\alpha_{a3}$ is the refractivity of air at a wavelength $\lambda_3$; and

- gas supply means comprising said purge gas.

  In this apsect, neither the diplacement measuring interferometer nor the second harmonic interferometer is required to provide an accurate measurement which takes into account purge gas contamination. Rather, this aspect ensures that the overall interferometric system is adjusted to account for the effect of purge gas contamination. This is achieved by off-setting the errors in the displacement measuring interferometer with those of the seond harmonic interferometer. This aspect of the invention provides an alternative manner in which the effects of temperature, pressure and leakage of purge gas may be accurately accounted for in the measurements of the interferometers and allows a simpler mixture of gases, for example only two different gases, to be used.

  According to a further aspect of the invention there is provided a lithographic apparatus as specified in the opening paragraph which is characterized by

- flushing gas means for supplying purge gas to a space, to displace therefrom ambient air, said space accommodating at least a part of said substrate table and/or at least a part of said table which is a part of said patterning means, wherein said purge gas is substantially non-absorbent of said projection beam of radiation;
- an interferometric displacement measuring means operating at a wavelength $\lambda_1$ for measuring the position of said substrate table or the position of said table which is a part of said patterning means; and
- a second harmonic interferometric measuring means operating at wavelengths $\lambda_2$ and $\lambda_3$ for adjusting the measurements of the said interferometric displacement measuring means (DI) according to the following equation:

$$L = (DI) - K(SHI) \qquad (9)$$

wherein L is the adjusted interferometric displacement measuring means measurement, SHI is the measurement of the second harmonic interferometric measuring means and K is a coefficient, the value of which is optimized such that the effects of variation in pressure, temperature and purge gas composition are partially eliminated from the adjusted measurement L.

In this aspect of the invention, the coefficient K is optimized in order to give the least possible error in the length measurement L. This embodiment is less demanding than the first three embodiments of the invention in terms of the specific combinations of gases which may be used and therefore provides a more cost effective manner in which the errors introduced by the purge gas compositional variation can be reduced.

According to a further aspect of the invention there is provided a device manufacturing method comprising the steps of:

- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target area of the layer of radiation-sensitive material,

characterized by the steps of

- determining the position of a table using interferometric displacement measuring means operating at a wavelength $\lambda_1$, said table either being suitable for holding said substrate or forming a part of said patterning means;
- providing purge gas to a space accommodating at least a part of said table to displace therefrom ambient air, wherein said purge gas is substantially non-absorbent of said projection beam of radiation and has a refractive index at a wavelength $\lambda_1$ which is substantially the same as that of air when measured at the same wavelength, temperature and pressure.

In a preferred embodiment, the method further comprises the step of adjusting the measurement of said interferometric displacement measuring means to substantially eliminate the effects of variation in pressure and temperature using a second harmonic interferometric measuring means operating at wavelengths $\lambda_2$ and $\lambda_3$. In this embodiment the purge gas comprises three or more different components, each component having refractivities at the wavelengths $\lambda_2$ and $\lambda_3$ such that the following equations are substantially fulfilled:

$$\sum_{j}^{k} F_j \alpha_{j1} = \alpha_{a1} \qquad (1)$$

$$\sum_{j}^{k} F_j (\alpha_{j3} - \alpha_{j2}) = \alpha_{a3} - \alpha_{a2} \qquad (2)$$

wherein $F_j$ is the fraction by volume of component j in the purge gas, which purge gas contains a total of k components, $\alpha_{j1}$ is the refractivity of component j at a wavelength $\lambda_1$, $\alpha_{j2}$ is the refractivity of component j at a wavelength $\lambda_2$, $\alpha_{j3}$ is the refractivity of component j at a wavelength $\lambda_3$, $\alpha_{a1}$ is the refractivity of air at a wavelength $\lambda_1$, $\alpha_{a2}$ is the refractivity of air at a wavelength $\lambda_2$ and $\alpha_{a3}$ is the refractivity of air at a wavelength $\lambda_3$, and wherein:

$$\sum_{j}^{k} F_j = 1. \qquad (3)$$

A further aspect of the invention provides a device manufacturing method comprising the steps of:

- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target area of the layer of radiation-sensitive material,

characterized by the steps of:

- determining the position of a table using interferometric displacement measuring means operating at a wavelength $\lambda_1$, said table either being suitable for holding said substrate or forming a part of said patterning means;
- adjusting the measurement of said interferometric displacement measuring means to substantially eliminate the effects of variation in pressure and temperature using a second harmonic interferometric measuring means operating at wavelengths $\lambda_2$ and $\lambda_3$;
- providing purge gas to a space accommodating at least a part of said table to displace therefrom ambient air, wherein said purge gas is substantially non-absorbent of said projection beam of radiation and comprises two or more components, each component having refractivities at the wavelengths $\lambda_1$, $\lambda_2$ and $\lambda_3$ such that the following equation is substantially fulfilled:

$$\frac{\alpha_{m1}}{(\alpha_{m3} - \alpha_{m2})} = K_a \qquad (4)$$

wherein $\alpha_{m1}$ is the refractivity of the purge gas at a wavelength $\lambda_1$, $\alpha_{m2}$ is the refractivity of the purge gas at a wavelength $\lambda_2$, $\alpha_{m3}$ is the refractivity of the purge gas at a wavelength $\lambda_3$ and

$$K_a = \frac{\alpha_{a1}}{(\alpha_{a3} - \alpha_{a2})} \qquad (5)$$

wherein $\alpha_{a1}$ is the refractivity of air at a wavelength $\lambda_1$, $\alpha_{a2}$ is the refractivity of air at a wavelength $\lambda_2$ and $\alpha_{a3}$ is the refractivity of air at a wavelength $\lambda_3$.

A further aspect of the invention provides a device manufacturing method comprising the steps of:

- providing a substrate that is at least partially covered by a layer of radiation-sensitive material;

-    providing a projection beam of radiation using a radiation system;
-    using patterning means to endow the projection beam with a pattern in its cross-section;
-    projecting the patterned beam of radiation onto a target area of the layer of radiation-sensitive material,

characterized by the steps of:

-    providing purge gas to a space accommodating at least a part of a table to displace therefrom ambient air, said table either being suitable for holding said substrate or forming a part of said patterning means, wherein said purge gas is substantially non-absorbent of said projection beam of radiation;
-    determining the position of said table using interferometric displacement measuring means operating at a wavelength $\lambda_1$; and
-    adjusting the measurement of said interferometric displacement measuring means (DI) using a second harmonic interferometric measuring means operating at wavelengths $\lambda_2$ and $\lambda_3$ according to the following equation:

$$L = (DI) - K(SHI) \qquad\qquad (9)$$

wherein L is the adjusted interferometric displacement measuring means measurement, SHI is the measurement of the second harmonic interferometric measuring means and K is a coefficient, the value of which is optimized such that the effects of variation in pressure, temperature and purge gas composition are partially eliminated from the adjusted value L.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target area", respectively.

In the present document, the terms illumination radiation and illumination beam are used to encompass all types of electromagnetic radiation, including ultraviolet radiation (e.g. with a wavelength of 365, 248, 193, 157 or 126 nm) and EUV, as well as particle beams, such as ion beams or electron beams.

Embodiments of the invention will now be described, by way of example only, with reference to the accompanying schematic drawings in which:

Figure 1 depicts a lithographic projection apparatus according to an embodiment of the invention;
Figure 2 shows the mask stage of the lithographic projection apparatus of Fig. 1 in more detail; and
Figure 3 depicts the substrate stage of the lithographic projection apparatus of Fig. 1 in more detail.

In the Figures, corresponding reference symbols indicate corresponding parts.

Embodiment 1

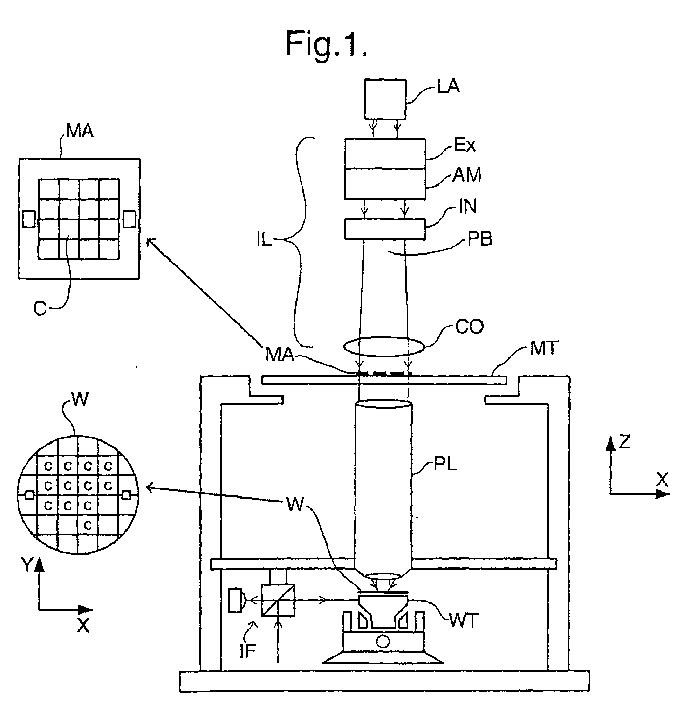

Figure 1 schematically depicts a lithographic projection apparatus according to a particular embodiment of the invention. The apparatus comprises:

·    a radiation system LA, Ex, IL, for supplying a projection beam-PB of radiation (e.g. U.V. or E.U.V. radiation, for example radiation having a wavelength of less than 180nm, for example about 157nm or 126nm);
·    a first object table (mask table) MT provided with a mask holder for holding a mask MA (e.g. a reticle), and connected to first positioning means for accurately positioning the mask with respect to item PL;
·    a second object table (substrate table) WT provided with a substrate holder for holding a substrate W *(e.g.* a resist-coated silicon wafer), and connected to second positioning means for accurately positioning the substrate with respect to item PL;
·    a projection system ("lens") PL (*e.g.* a refractive or catadioptric system of a mirror group) for imaging an irradiated portion of the mask MA onto a target portion C (comprising one or more dies) of the substrate W.

As here depicted, the apparatus is of a transmissive type (*i.e* has a transmissive mask). However, in general, it may also be of a reflective type, for example (with a reflective mask). Alternatively, the apparatus may employ another kind of patterning means, such as a programmable mirror array of a type as referred to above.

The radiation system comprises a source LA *(e.g.* an Hg lamp or an excimer laser) that produces a beam of radiation. This beam is fed into an illumination system (illuminator) IL, either directly or after being passed through conditioning means, such as a beam expander Ex, for example. The illuminator IL comprises adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA which is held in a mask holder on a mask table MT. Having traversed the mask MA, the beam PB passes through the lens PL, which focuses the beam PB onto a target portion C of the substrate W. With the aid of the second positioning means (and interferometric measuring means IF comprising an interferometric displacement measuring device operating at a wavelength $\lambda_1$, for example at about 633nm), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long stroke module (coarse positioning) and a short stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:

1. In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;

2. In scan mode, essentially the same scenario applies, except that a given target portion C is not exposed in a single "flash". Instead, the mask table MT is movable in a given direction (the so-called "scan direction", *e.g.* the x direction) with a speed v, so that the projection beam PB is caused to scan over a mask image; concurrently, the substrate table WT is simultaneously moved in the same or opposite direction at a speed $V = Mv$, in which $M$ is the magnification of the lens PL (typically, $M = 1/4$ or $1/5$). In this manner, a relatively large target portion C can be exposed, without having to compromise on resolution.

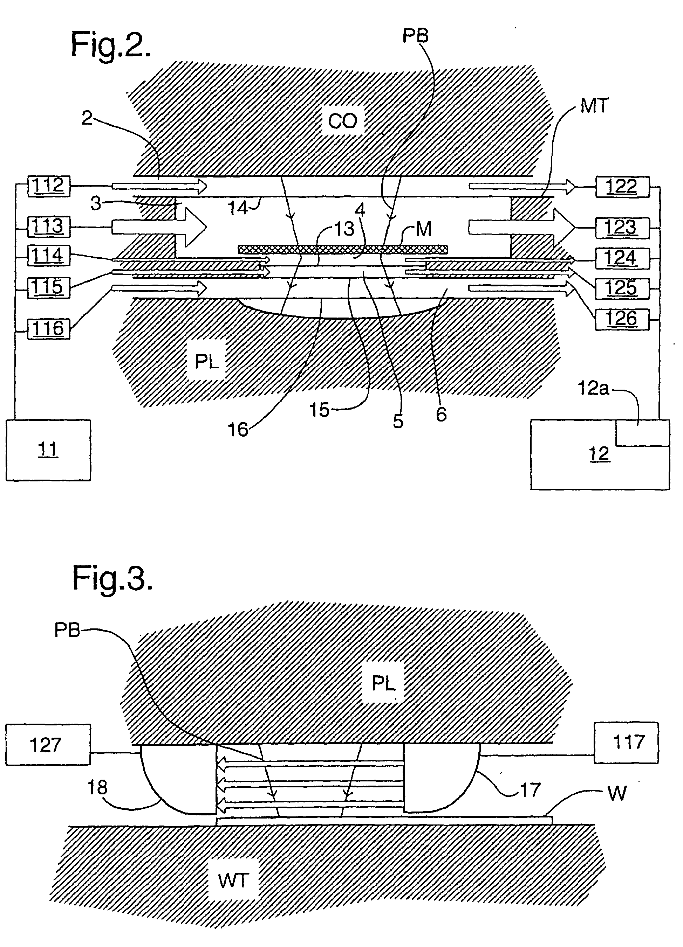

Figure 2 shows the mask stage, comprising mask table MT, of the lithographic apparatus according to the invention in more detail.

It will be seen that the mask M is held in a recess in mask table MT, which can be manufactured from a ceramic material such as Zerodur (RTM) and is positioned by a drive system (not shown) during operation of the lithographic apparatus. The mask table MT is closely sandwiched between the last element of the collimating optics CO, which generate the projection beam PB, and the first element of the projection lens system PL, which projects the projection beam PB, having passed through the mask M, onto the wafer W (shown in figures 1 and 3).

The mask stage may be divided into zones or spaces 2 to 6 as follows: space 2 is between the final illuminator optics CO and mask table MT; space 3 is within the mask table MT above the mask M; space 4 is within the mask table MT, between the mask M and pellicle 13; space 5 is within the mask table MT below the pellicle 13; and space 6 is between the mask table MT and projection lens system PL. Each of the spaces is flushed with a purge gas provided from gas supply 11 via respective flow regulators 112 to 116. At the other side of each space the purge gas is removed to reservoir 12 via respective vacuum pumps 122 to 126. Reservoir 12 may be partitioned to allow controlled re-use of the gas in selected spaces and may included devices 12a to clean or scrub the recovered gas.

If desired, the various spaces in the mask stage can be separated from one another to ensure laminar flow. For example, a thin sheet 14, e.g. of CaF or fused $SiO_2$, may be provided to cover the recess in the mask table MT and separate space 2 from space 3. Similarly, sheets 15 and 16 may be used to separate spaces 5 and 6, and to cover the non-flat surface of the first element of the projection lens system PL, respectively.

To supply and remove the gas flow to spaces 3, 4 and 5, within the mask table MT, appropriate conduits are provided in the body of the mask table. When the mask table has been exposed to air, e.g. after a period of non-operation of the apparatus or after mask exchange, purge gas is supplied for a short period before an exposure is taken to flush out any air that may have accumulated, e.g. in non-flat parts of the mask table.

Figure 3 shows the wafer stage of the lithographic apparatus of Figure 1. To avoid having to provide a purge gas path covering the entire range of movement of the wafer stage, the flushing gas supply outlets 17 and evacuation inlets 18 are mounted on the lower end of the projection lens system PL, either side of the final element. Outlets 17 and inlets 18 are respectively connected to the gas supply 11 and reservoir 12 via flow regulator 117 and vacuum pump 127 respectively. The outlets 17 in particular, but also the inlets 18, may be provided with vanes to guide the flow of purge gas. If not already flat, the final element of the projection lens system PL may be covered with a thin sheet as discussed above.

The flow regulators 112 to 117 mentioned above may comprise static or controllable pressure or flow reducers and/or blowers as required to provide the necessary gas flow rates for the particular embodiment and the available gas supply.

According to the invention, the mask stage and/or the substrate stage of the apparatus may be flushed with a purge gas. The purge gas typically comprises a mixture of two or more gases selected from $N_2$, He, Ne, Ar, Kr and Xe. The gas composition used is one which is substantially transparent to UV radiation of the wavelength of the projection beam and has a refractive index which is substantially the same as that of air, when measured under the same conditions of temperature and pressure (e.g. standard clean room conditions) and using radiation of the same wavelength. The refractive index should be the same as that of air at the wavelength of a radiation beam used in the interferometric displacement measuring means IF. The pressure of the purge gas in the mask and/or substrate stages may be atmospheric pressure, or it may be above atmospheric pressure so that any leak results in an outflow of gas rather than contaminating the system with incoming air.

To determine which mixtures of gases are suitable for use in the present invention, the refractive index of the mixture must be known. The refractive index $n_1$ of a mixture of k gases at a specific partial pressure, temperature and at a wavelength $\lambda_1$ can be determined using the following equation:

$$n_1 - 1 = \sum_{j}^{k} F_j(n_{j1} - 1) \qquad (6)$$

wherein $n_{j1}$ is the refractive index of the pure gas j at a wavelength $\lambda_1$.

The refractivity $\alpha$ is related to the refractive index n, via the equation:

$$\alpha_1 = n_1 - 1 \qquad (6a)$$

Thus, for the mixture of k gases

$$\alpha_1 = \sum_{j}^{k} F_j \alpha_{j1} \qquad (7)$$

where $F_j$ is the relative volume concentration of the gas j, and $\alpha_{j1}$, is the refractivity of the pure gas j at a wavelength $\lambda_1$. Thus, for the purposes of this embodiment of the present invention, if the purge gas consists of a mixture of gases x and y, the relative volume concentrations of the two gases must comply with the equation:

$$\alpha_{a1} = F_x \alpha_{x1} + F_y \alpha_{y1} \qquad (8)$$

where $\alpha_{al}$ is the refractivity of air at a wavelength $\lambda_1$. Or, more generally,

$$\sum_{j}^{k} F_j \alpha_{j1} = \alpha_{a1} \qquad (1)$$

wherein $F_j$, $\alpha_{j1}$ and $\alpha_{a1}$ are as defined above and wherein

$$\sum_{j}^{k} F_j = 1 \qquad\qquad (3)$$

Refractivities and refractive indices are dependent on pressure, temperature and wavelength, thus all values of n and $\alpha$ in the above equations, and all other equations mentioned herein, must relate to the same temperature and pressure. Typically standard clean room conditions are used. The wavelength used for the calculations, $\lambda_1$, should be the same as that of at least one of the radiation beams of the interferometric displacement measuring means.

Suitable mixtures of gases which comply with this equation include mixtures comprising $N_2$ and either from 1 to 5 vol.% He, preferably from 2 to 3 vol.% He; from 1 to 5 vol.% Ne, preferably from 3.5 to 2.5 vol.% Ne; or from 35 to 50 vol.% Ar, preferably from 40 to 45 vol.% Ar; mixtures comprising Ar and from 1 to 5 vol.% Xe, preferably from 2 to 3 vol.% Xe; mixtures comprising Ar and from 5 to 10 vol.% Kr, preferably from 6 to 8 vol.% Kr; and mixtures comprising $N_2$, from 0.5 to 3 vol.% He and from 0.5 to 3 vol.% Xe. Preferred mixtures of gases, for use with a wavelength $\lambda_1$ of 633nm, include those set out in Table 1 below. All figures are in % by volume.

Table 1:

| Example | $N_2$ | He | Ne | Ar | Kr | Xe |
|---------|------|-----|-----|------|-----|-----|
| 1 | 97.3 | 2.7 | | | | |
| 2 | 97.0 | | 3.0 | | | |
| 3 | 59.0 | | | 41.0 | | |
| 4 | | | | 97.5 | | 2.5 |
| 5 | | | | 92.9 | 7.1 | |

<u>Embodiment 2</u>

In this embodiment of the invention, which is the same as the first embodiment except as described below, the interferometric measuring means IF comprises an interferometric displacement measuring device and a second harmonic interferometric device. The second harmonic interferometric device measures the refractivity of the atmosphere in the apparatus at two different wavelengths. In this manner it is possible to determine the effects of pressure and temperature on the refractivity and therefore to adjust accordingly the measurement of the displacement interferometer to account for such variations.

This is achieved by multiplying the measurement of the second harmonic interferometer by a coefficient $K_a$ and subsequently subtracting this value from the displacement interferometer measurement. Thus, the corrected length, L is given by

$$L = (DI) - K_a(SHI) \qquad\qquad (9)$$

wherein DI is the displacement interferometer measurement and SHI is the second harmonic interferometer measurement, wherein DI and SHI are corrected for operation in average air.

The coefficient $K_a$ is determined as follows:

$$K_a = \frac{\alpha_{a1}}{(\alpha_{a3} - \alpha_{a2})} \qquad\qquad (5)$$

wherein $\alpha_{ay}$ is the refractivity of air at a wavelength $\lambda_y$ and wherein the interferometric displacement measuring means is operated at a wavelength $\lambda_1$ and the second harmonic interferometric measuring means is operated at wavelengths $\lambda_2$ and $\lambda_3$, with the wavelength $\lambda_2$ typically being greater than the wavelength $\lambda_3$. For example $\lambda_2$ may be about 532nm and $\lambda_3$ about 266nm. Typically, $\lambda_1$ is different from $\lambda_2$ and $\lambda_3$. However, it is possible for $\lambda_1$ to be equal either to $\lambda_2$ or to $\lambda_3$.

The adjustment of the displacement interferometer measurement in this manner ensures that the positional measurement is not affected by variations in temperature and pressure inside the lithographic apparatus.

The selection of a purge gas having a refractive index (or refractivity) the same as air at a wavelength $\lambda_1$ ensures that the displacement interferometric device is accurate even when purge gas leaks into the measurement area. However, leakage of the purge gas may still cause significant inaccuracies in the refractivity measurements at the wavelengths $\lambda_2$ and $\lambda_3$ at which the second harmonic interferometer operates. This, in turn, can cause errors in the final positional measurement. The present embodiment of the invention accounts for this problem by ensuring that leakage of the purge gas has no effect on either interferometric device. This can be achieved using a purge gas comprising k gases, k being three or more, and fulfilling, or substantially fulfilling, the following three equations:

$$\alpha_{a1} = \sum_{j}^{k} F_j \alpha_{j1} \qquad (1)$$

$$\sum_{j}^{k} F_j(\alpha_{j3} - \alpha_{j2}) = \alpha_{a3} - \alpha_{a2} \qquad (2)$$

$$\sum_{j}^{k} F_j = 1. \qquad (3)$$

wherein F, $\alpha$, j and k are as defined above.

By solving the above three equations simultaneously, the required fraction of each of the gases j can be determined. The fulfillment of equation (1) ensures that the refractivity (or refractive index) of the mixture at a wavelength $\lambda_1$ is the same as that of air when measured at the same wavelength, temperature and pressure.

Suitable mixtures of gases for use in this embodiment include mixtures of three or more components having different refractivities. For example, the purge gas may comprise one or more components having a refractivity of less than $1 \times 10^{-4}$ at a wavelength of from 200 to 700nm and two or more components having refractivites of greater than $1 \times 10^{-4}$ at a wavelength of from 200 to 700nm. Typically, the component having a refractivity of less than $1 \times 10^{-4}$ at a wavelength of from 200 to 700nm will be present in an amount of from 1 to 40%, preferably 2 to 20% by volume and the two or more components having refractivites of greater than $1 \times 10^{-4}$ at a wavelength of from 200 to 700nm will be present in an amount of from 60 to 99%, preferably 80 to 98% by volume.

For example, the purge gas may comprise three of more gases selected from $N_2$, He, Ne, Ar, Kr and Xe. Typically, the purge gas comprises He and/or Ne together with two or more gases selected from $N_2$, Ar, Kr and Xe. More preferably, the purge gas comprises He and/or Ne; Ar and/or $N_2$; and Kr and/or Xe.

Typically, the purge gas comprises He and/or Ne in an amount of from 1 to 40%, preferably 2 to 20%, more preferably from 4 to 16% by volume and two or more gases selected from $N_2$, Ar, Kr and Xe in an amount of from 60 to 99%, preferably 80 to 98%, more preferably 84 to 96% by volume. For example, the purge gas may comprise He and/or Ne in an amount of from 2 to 20%, preferably from 4 to 16% by volume; Ar and/or $N_2$ in an amount of from 50 to 96%, preferably from 60 to 92% by volume; and Kr or Xe in an amount of from 2 to 40%, preferably from 3 to 30 % by volume. Most preferably, the purge gas comprises He and/or Ne in an amount of from 2 to 20%, preferably from 4 to 16% by volume; together with (i) Ar and/or $N_2$ in an amount of from 50 to 70% by volume and Kr in an amount of from 10 to 40% by volume; or (ii) Ar and/or $N_2$ in an amount of from 70 to 90 % by volume and Xe in an amount of from 0.5 to 20 % by volume.

Preferred purge gases according to this embodiment include those set out in Table 2 below. All figures are given in % by volume.

Table 2:

| Example | $N_2$ | He | Ne | Ar | Kr | Xe |
|---------|------|------|------|------|------|-----|
| 6 | 66.4 | 12.7 | | | 20.9 | |
| 7 | 60.7 | | 15.9 | | 23.4 | |
| 8 | | 9.5 | | 67.6 | 23.0 | |
| 9 | | | 12.1 | 63.1 | 24.8 | |

Table continued

| Example | N$_2$ | He | Ne | Ar | Kr | Xe |
|---|---|---|---|---|---|---|
| 10 | 87.1 | 8.8 | | | | 4.2 |
| 11 | 84.9 | | 10.6 | | | 4.5 |
| 12 | | 3.9 | | 91.4 | | 4.8 |
| 13 | | | 4.7 | 90.4 | | 4.9 |

Embodiment 3

In the third embodiment of the invention, which is the same as the first embodiment except as described below, a second harmonic interferometric device is used to adjust the measurements of the displaement interferometer to account for variations in temperature and pressure. The second harmonic interferometric device is described in Embodiment 2 above. In this third embodiment, the response of the overall interferometric system is adjusted to account for purge gas contamination. This is achieved by off-setting the errors caused by purge gas contamination in each of the two interferometric devices.

In this embodiment, at least two components make up the purge gas, and the following equation must be susbtantially fulfilled:

$$\frac{\alpha_{m1}}{(\alpha_{m3} - \alpha_{m2})} = K_a \qquad (4)$$

wherein $\alpha_{m1}$, $\alpha_{m2}$ and $\alpha_{m3}$ are as defined above; and

$$K_a = \frac{\alpha_{a1}}{(\alpha_{a3} - \alpha_{a2})} \qquad (5)$$

wherein $\alpha_{a1}$, $\alpha_{a2}$ and $\alpha_{a3}$ are as defined above. As for embodiments 1 and 2, the sum of the gaseous fractions must equal 1, thus

$$\sum_{j}^{k} F_j = 1 \qquad (3)$$

wherein F, j and k are as defined above.

The refractivity of the purge gas for wavelength $\lambda_1$ is given by:

$$\sum_{j}^{k} F_j \alpha_{j1} = \alpha_{m1} \qquad (10)$$

For wavelength $\lambda_2$ said refractivity is given by:

$$\sum_{j}^{k} F_j \alpha_{j2} = \alpha_{m2} \qquad (11)$$

and for $\lambda_3$

$$\sum_{j}^{k} F_j \alpha_{j3} = \alpha_{m3} \qquad (12)$$

with the condition that

$$\sum_{j}^{k} F_j \approx 1 \qquad (3)$$

Different purge gas compositions can be calculated by combining equations (10), (11) and (12) with the condition that equations (3), (4) and (5) must be fulfilled. For more information with regard to refractivity see, for example, Max Born & Emil Wolf, Principles of optics, electric theory of propagation interference and diffraction of light, sixth edition, Pergamon Press Oxford, incorporated herein by reference.

Suitable mixtures of gases include mixtures of two or more components having different refractivities. For example, the purge gas may comprise one or more components having a refractivity of less than $3 \times 10^{-4}$ at a wavelength of from 200 to 700nm and one or more components having a refractivity of greater than $3 \times 10^{-4}$ at a wavelength of from 200 to 700nm. Typically, the one or more components having a refractivity of less than $3 \times 10^{-4}$ at a wavelength of from 200 to 700nm will be present in an amount of from 50 to 99% by volume and the one or more components having a refractivity of greater than $3 \times 10^{-4}$ at a wavelength of from 200 to 700nm will be present in an amount of from 1 to 50% by volume. The refractive index (or refractivity) of the purge gas mixture at a wavelength $\lambda_1$ differs from that of air when measured at the same wavelength, temperature and pressure.

For example, the purge gas may comprise two of more gases selected from $N_2$, He, Ne, Ar, Kr and Xe. Typically, the purge gas comprises one or more gases selected from $N_2$, He, Ne and Ar together with Kr and/or Xe.

Typically, the purge gas comprises $N_2$, He, Ne and/or Ar in an amount of from 50 to 99%, preferably from 65 to 98% by volume and Kr and/or Xe in an amount of from 1 to 50%, preferably 2 to 35% by volume. For example, the purge gas may comprise $N_2$, He, Ne and/or Ar in an amount of from 65 to 90% by volume and Kr in an amount of from 10 to 35% by volume. Alternatively, the purge gas may comprise $N_2$, He, Ne and/or Ar in an amount of from 90 to 98% by volume and Xe in an amount of from 2 to 10% by volume.

Preferred purge gases according to this embodiment include those set out in Table 3 below. All figures are given in % by volume.

Table 3:

| Example | $N_2$ | He | Ne | Ar | Kr | Xe |
|---------|-------|------|------|------|------|-----|
| 14 | 78.6 | | | | 21.4 | |
| 15 | 95.7 | | | | | 4.3 |
| 16 | | 82.1 | | | 17.9 | |
| 17 | | 96.6 | | | | 3.4 |
| 18 | | | 69.8 | | 30.2 | |
| 19 | | | 93.4 | | | 6.6 |
| 20 | | | | 76.4 | 23.6 | |
| 21 | | | | 95.2 | | 4.8 |

Embodiment 4

According to a further embodiment of the invention, which is the same as the first embodiment except as described below, an apparatus may be used that typically only partially compensates for the effects of temperature, pressure and purge gas contamination. This embodiment may be particularly relevant where the expense or availability of certain components of the preferred purge gas, for example Kr or Xe are prohibitive.

In this embodiment, the correction coefficient, K, determined by the second harmonic interferometric device may be optimized such that the correction to account for pressure and temperature variation is not quite accurate, but that the errors introduced by the contamination with purge gas are corrected to some extent. Thus, simultaneous correction of pressure, temperature and purge gas errors using an approximate value of the second harmonic interferometer coefficient is used.

The approximate coefficient may be calculated as described below. In this calculation scheme $\alpha_{jx}$, $\alpha_{mx}$ and $\alpha_{ax}$ represent the refractivity of a gas j, the purge gas or air respectively at a wavelength $\lambda_x$ and $\alpha_{cx}$ represents the refractivity of air contaminated by a relative amount c of the purge gas:

$$\alpha_{cx} = (1-c)\alpha_{ax} + c\alpha_{mx} \qquad (13)$$

Both turbulence and contamination of the air in the path of the displacement measuring interferometer cause changes in the observed index of refraction of the air in the measurement path. The error, E, in the measured distance is given by

$$E = (\Delta\alpha_{c1} - K\Delta(\alpha_{c3} - \alpha_{c2}))L \qquad (14)$$

Here L is the length of the measurement path of the displacement measuring interferometer, $\Delta\alpha_{c1}$ is the change in the refractivity at a wavelength $\lambda_1$ and $\Delta(\alpha_{c3}-\alpha_{c2})$ is the change in the difference in refractivity between the wavelengths $\lambda_2$ and $\lambda_3$ of the second harmonic interferometer system. The refractivities are proportional to the quotient pressure (p) over absolute temperature (T), so, accounting for pressure and temperature effects only, $\Delta\alpha_{c1}$ and $\Delta(\alpha_{c3}-\alpha_{c2})$ are given by:

$$\Delta\alpha_{c1} = \alpha_{c1}\frac{\Delta\rho}{\rho_0} \qquad (15)$$

$$\Delta(\alpha_{c3} - \alpha_{c2}) = (\alpha_{c3} - \alpha_{c2})\frac{\Delta\rho}{\rho_0} \qquad (16)$$

wherein $\rho = p/T$ and $\Delta\rho$ is the variation in $\rho$.

Accounting for the variation in the relative amount of contamination by the purge gas, $\Delta c$, $\Delta\alpha_{c1}$ and $\Delta(\alpha_{c3}-\alpha_{c2})$ are given by

$$\Delta\alpha_{c1} = \Delta c(\alpha_{m1} - \alpha_{a1}) \qquad (17)$$

$$\Delta(\alpha_{c3} - \alpha_{c2}) = \Delta c(\alpha_{m3} - \alpha_{a3} - \alpha_{m2} + \alpha_{a2}) \qquad (18)$$

If $\sigma_\rho$ is the standard deviation of $\rho$, then the standard deviation of the error due to turbulence ($\sigma_E$, $\rho$) is given by:

$$\sigma_{E,\rho} = \frac{\sigma_\rho}{\rho}(\alpha_{c1} - K(\alpha_{c3} - \alpha_{c2}))L \qquad (19)$$

If $\sigma_c$ is the standard deviation of c, then the standard deviation of the error due to purge gas contamination ($\sigma_{E,c}$) is given by:

$$\sigma_{E,c} = \sigma_C((\alpha_{m1} - \alpha_{a1}) - K(\alpha_{m3} - \alpha_{m2} - \alpha_{a3} + \alpha_{a2}))L \qquad (20)$$

The total variance of the length measurement is given by

$$\sigma_T^2 = \sigma_{E,p}^2 + \sigma_{E,c}^2$$

$$\sigma_T^2 = L^2[(\alpha_{c1})^2 - 2K(\alpha_{c3} - \alpha_{c2})(\alpha_{c1}) + K^2(\alpha_{c3} - \alpha_{c2})^2]\left(\frac{\sigma_p}{\rho}\right)^2 \qquad (21)$$

$$+[(\alpha_{m1} - \alpha_{a1})^2 - 2K(\alpha_{m1} - \alpha_{a1})(\alpha_{m3} - \alpha_{a3} - \alpha_{m2} + \alpha_{a2}) + K^2(\alpha_{m3} - \alpha_{a3} - \alpha_{m2} + \alpha_{a2})^2]\sigma_C^2$$

The optimum value of K can be found by setting $\dfrac{\partial(\sigma_T^2)}{\partial K} = 0$. The resulting optimum value for K is given by

$$K = \frac{(\alpha_{c3} - \alpha_{c2})(\alpha_{c1})\left(\dfrac{\sigma_p}{\rho_0}\right)^2 + (\alpha_{m1} - \alpha_{a1})(\alpha_{m3} - \alpha_{m2} - \alpha_{a3} + \alpha_{a2})\sigma_C^2}{(\alpha_{c3} - \alpha_{c2})^2\left(\dfrac{\sigma_p}{\rho_0}\right)^2 + (\alpha_{m3} - \alpha_{m2} - \alpha_{a3} + \alpha_{a2})^2\sigma_C^2} \qquad (22)$$

The value of K given by this formula thus provides simultaneous, although not necessarily complete, correction of the pressure, temperature and purge gas errors. When the variance in contamination is zero, the above formula reduces to formula (5), i.e. that usually used to correct for pressure and temperature alone.

The purge gas used in this embodiment may have a refractive index which differs from that of air at a wavelength $\lambda_1$. In another aspect of the embodiment the purge gas has a refractive index at a wavelength $\lambda_1$, which is similar to, or substantially the same as, that of air at the same wavelength, temperature and pressure.

It should be noted that the use of helium or neon alone, or predominantly alone, may be used in this embodiment of the present invention. Thus, the purge gas may comprise at least 90%, preferably at least 95% or 98% of either helium or neon alone or of a mixture of these gases. Both gases have very low refractivities and the variation in their refractivites between the wavelengths commonly employed in the interferometric devices in lithographic equipment is small. Contamination of the interferometric measurement area with one of these two gases acts effectively as if the pressure in the chamber has been reduced, and this can be compensated for in the usual manner by the second harmonic interferometric device. The advantage of this aspect of the embodiment is that helium and neon, in particular helium, are relatively inexpensive gases. Further, when an approximate coefficient K is calculated, the use of such coefficient results in very little total error.

The combination of helium or neon, however, with nitrogen provides an improved system which retains the low overall error, but the extent to which the errors produced by the two different interferometers are off-set against one another is much lower. This has the additional advantage that small fractional errors in either of the two interferometers will cause a smaller overall error in the result produced by the interferometric system. Therefore, an alternative purge gas for use in this embodiment of the invention comprises a mixture of helium and/or neon with nitrogen. For example a mixture of from 90 to 99% by volume nitrogen and from 1 to 10% by volume helium and/or neon, or more preferably from 94 to 96% by volume nitrogen and from 4 to 6% by volume helium and/or neon.

Whilst specific embodiments of the invention have been described above, it will be appreciated that the invention may be practiced otherwise than as described. The description is not intended to limit the invention.

**Claims**

1. A lithographic projection apparatus comprising:

    - a radiation system for providing a projection beam of radiation;
    - patterning means for patterning the projection beam according to a desired pattern;
    - a substrate table for holding a substrate;
    - a projection system for imaging the patterned beam onto a target portion of the substrate,

    **characterized by**:

    - an interferometric displacement measuring means operating at a wavelength $\lambda_1$ for measuring the position of said substrate table or the position of a table which is a part of said patterning means;
    - flushing gas means for supplying purge gas to a space, to displace therefrom ambient air, said space accommodating at least a part of said substrate table and/or at least a part of said table which is a part of said patterning means, wherein said purge gas is substantially non-absorbent of said projection beam of radiation and has a refractive index at a wavelength $\lambda_1$ which is substantially the same as that of air when measured at the same wavelength, temperature and pressure; and
    - gas supply means comprising said purge gas.

2. An apparatus according to claim 1 wherein the purge gas comprises two or more components selected from $N_2$, He, Ar, Kr, Ne and Xe.

3. An apparatus according to claim 2 wherein said purge gas comprises at least 95% by volume $N_2$ and at least 1% by volume He.

4. An apparatus according to claim 2 wherein said purge gas comprises at least 95% by volume Ar and at least 1 % by volume Xe.

5. An apparatus according to claim 2 wherein said purge gas comprises at least 90% by volume Ar and at least 5% by volume Kr.

6. An apparatus according to claim 2, wherein said purge gas comprises at least 95% by volume $N_2$ and at least 1% by volume Ne.

7. An apparatus according to claim 2, wherein said purge gas comprises at least 50% by volume $N_2$ and at least 35% by volume Ar.

8. An apparatus according to claim 2 wherein said purge gas comprises at least 94% by volume $N_2$, at least 0.5% by volume He and at least 0.5% by volume Xe.

9. An apparatus according to claim 1, which further comprises a second harmonic interferometric measuring means operating at wavelengths $\lambda_2$ and $\lambda_3$ for adjusting the measurements of said interferometric displacement measuring means to substantially eliminate the effects of variation in pressure and temperature, and wherein said purge gas comprises three or more different components, each component having refractivities at the wavelengths $\lambda_2$ and $\lambda_3$ such that the following equations are substantially fulfilled:

$$\sum_{j}^{k} F_j \alpha_{j1} = \alpha_{a1} \tag{1}$$

$$\sum_{j}^{k} F_j(\alpha_{j3} - \alpha_{j2}) = \alpha_{a3} - \alpha_{a2} \qquad (2)$$

wherein $F_j$ is the fraction by volume of component j in the purge gas, which purge gas contains a total of k components, $\alpha_{j1}$ is the refractivity of component j at a wavelength $\lambda_1$, $\alpha_{j2}$ is the refractivity of component j at a wavelength $\lambda_2$, $\alpha_{j3}$ is the refractivity of component j at a wavelength $\lambda_3$, $\alpha_{a1}$ is the refractivity of air at a wavelength $\lambda_1$, $\alpha_{a2}$ is the refractivity of air at a wavelength $\lambda_2$ and $\alpha_{a3}$ is the refractivity of air at a wavelength $\lambda_3$; and wherein:

$$\sum_{j}^{k} F_j = 1 \qquad (3)$$

10. An apparatus according to claim 9, wherein said purge gas comprises three or more different components selected from $N_2$, He, Ar, Kr, Ne and Xe.

11. An apparatus according to claim 10, wherein said purge gas comprises (i) $N_2$ and/or Ar in an amount of from 50-90% by volume, (ii) Xe and/or Kr in an amount of from 0.5 to 40% by volume and (iii) He and/or Ne in an amount of from 2 to 20% by volume.

12. A lithographic projection apparatus comprising a radiation system, patterning means, substrate table and projection system as defined in claim 1, **characterized by**:

- an interferometric displacement measuring means as defined in claim 1;
- a second harmonic interferometric measuring means operating at wavelengths $\lambda_2$ and $\lambda_3$ for adjusting the measurements of the said interferometric displacement measuring means to substantially eliminate the effects of variation in pressure and temperature;
- flushing gas means for supplying purge gas to a space, to displace therefrom ambient air, said space accommodating at least a part of said substrate table and/or at least a part of said table which is a part of said patterning means, wherein said purge gas is substantially non-absorbent of said projection beam of radiation and comprises two or more components, each component having refractivities at the wavelengths $\lambda_1$, $\lambda_2$ and $\lambda_3$ such that the following equation is substantially fulfilled:

$$\frac{\alpha_{m1}}{(\alpha_{m3} - \alpha_{m2})} = K_a \qquad (4)$$

wherein $\alpha_{m1}$ is the refractivity of the purge gas at a wavelength $\lambda_1$, $\alpha_{m2}$ is the refractivity of the purge gas at a wavelength $\lambda_2$, $\alpha_{m3}$ is the refractivity of the purge gas at a wavelength $\lambda_3$ and

$$K_a = \frac{\alpha_{a1}}{(\alpha_{a3} - \alpha_{a2})} \qquad (5)$$

wherein $\alpha_{a1}$ is the refractivity of air at a wavelength $\lambda_1$ and $\alpha_{a2}$ and $\alpha_{a3}$ are as defined in claim 9; and
- gas supply means comprising said purge gas.

13. An apparatus according to claim 12, wherein said purge gas comprises two or more gases selected from $N_2$, He, Ar, Kr, Ne and Xe.

14. An apparatus according to claim 13, wherein said purge gas comprises (i) $N_2$, He, Ar and/or Ne in an amount of from 65 to 99.5% by volume and (ii) Kr and/or Xe in an amount of from 0.5 to 35% by volume.

15. A lithographic projection apparatus comprising a radiation system, patterning means, substrate table and projection system as defined in claim 1, **characterized by**:

- flushing gas means for supplying purge gas to a space, to displace therefrom ambient air, said space accommodating at least a part of said substrate table and/or at least a part of said table which is a part of said patterning means, wherein said purge gas is substantially non-absorbent of said projection beam of radiation;
- an interferometric displacement measuring means as defined in claim 1; and
- a second harmonic interferometric measuring means operating at wavelengths $\lambda_2$ and $\lambda_3$ for adjusting the measurements of the said interferometric displacement measuring means (DI) according to the following equation:

$$L=(DI) - K(SHI) \qquad (9)$$

wherein L is the adjusted interferometric displacement measuring means measurement, SHI is the measurement of the second harmonic interferometric measuring means and K is a coefficient, the value of which is optimized such that the effects of variation in pressure, temperature and purge gas composition are partially eliminated from the adjusted measurement L.

16. An apparatus according to claim 15, wherein said purge gas has a refractive index at a wavelength $\lambda_1$ which is substantially the same as that of air when measured at the same wavelength, temperature and pressure.

17. An apparatus according to claim 15 or 16, wherein K is given by the equation:

$$K = \frac{(\alpha_{c3} - \alpha_{c2})(\alpha_{c1})\left(\frac{\sigma_\rho}{\rho_0}\right)^2 + (\alpha_{m1} - \alpha_{a1})(\alpha_{m3} - \alpha_{m2} - \alpha_{a3} + \alpha_{a2})\sigma_C^2}{(\alpha_{c3} - \alpha_{c2})^2\left(\frac{\sigma_\rho}{\rho_0}\right)^2 + (\alpha_{m3} - \alpha_{m2} - \alpha_{a3} + \alpha_{a2})^2\sigma_C^2} \qquad (22)$$

wherein $\alpha_{mx}$ and $\alpha_{ax}$ represent the refractivity of the purge gas or air respectively at a wavelength $\lambda_x$ and $\alpha_{cx}$ represents the refractivity of air contaminated by a relative amount c of the purge gas at a wavelength $\lambda_x$, p represents quotient pressure divided by absolute temperature, $\sigma_\rho$ is the standard deviation of $\rho$ and $\sigma_c$ is the standard deviation of c.

18. An apparatus according to any one of claims 15 to 17, wherein the purge gas comprises at least 95% by volume He.

19. An apparatus according to any one of claims 15 to 17, wherein the purge gas comprises from 94 to 96% by volume $N_2$ and from 4 to 6% by volume He.

20. An apparatus according to any one of the preceding claims wherein $\lambda_1$ is about 633nm, $\lambda_2$ is about 532nm and $\lambda_3$ is about 266nm.

21. An apparatus according to any one of the preceding claims, wherein said flushing gas means comprises a supply of purge gas as defined in any one of the preceding claims, a gas flow regulator for controlling the rate of flow of purge gas to said space and evacuation means for removing purge gas from said space.

22. An apparatus according to claim 21 wherein said flow regulator comprises a flow restrictor.

23. An apparatus according to claim 21 or 22 wherein said flow regulator comprises a blower.

24. An apparatus according to any one of the preceding claims wherein said radiation of said projection beam has a wavelength less than about 180nm, preferably about 157nm or 126 nm.

25. A device manufacturing method comprising the steps of:

a) providing a substrate that is at least partially covered by a layer of radiation-sensitive material;
b) providing a projection beam of radiation using a radiation system;
c) using patterning means to endow the projection beam with a pattern in its cross-section;
d) projecting the patterned beam of radiation onto a target area of the layer of radiation-sensitive material,
e) determining the position of a table using interferometric displacement measuring means operating at a wavelength $\lambda_1$, said table either being suitable for holding said substrate or forming a part of said patterning means;

**characterized by** the step of

- providing purge gas to a space accommodating at least a part of said table to displace therefrom ambient air, wherein said purge gas is substantially non-absorbent of said projection beam of radiation and has a refractive index at a wavelength $\lambda_1$ which is substantially the same as that of air when measured at the same wavelength, temperature and pressure.

26. A method according to claim 25, which further comprises the step of adjusting the measurement of said interferometric displacement measuring means to substantially eliminate the effects of variation in pressure and temperature using a second harmonic interferometric measuring means operating at wavelengths $\lambda_2$ and $\lambda_3$; and wherein said purge gas comprises three or more different components, each component having refractivities at the wavelengths $\lambda_2$ and $\lambda_3$ such that the following equations are substantially fulfilled:

$$\sum_{j}^{k} F_j \alpha_{j1} = \alpha_{a1} \qquad (1)$$

$$\sum_{j}^{k} F_j (\alpha_{j3} - \alpha_{j2}) = \alpha_{a3} - \alpha_{a2} \qquad (2)$$

wherein $F_j$ is the fraction by volume of component j in the purge gas, which purge gas contains a total of k components, $\alpha_{j1}$ is the refractivity of component j at a wavelength $\lambda_1$, $\alpha_{j2}$ is the refractivity of component j at a wavelength $\lambda_2$, $\alpha_{j3}$ is the refractivity of component j at a wavelength $\lambda_3$, $\alpha_{a1}$ is the refractivity of air at a wavelength $\lambda_1$, $\alpha_{a2}$ is the refractivity of air at a wavelength $\lambda_2$ and $\alpha_{a3}$ is the refractivity of air at a wavelength $\lambda_3$, and wherein:

$$\sum_{j}^{k} F_j = 1 \qquad (3)$$

27. A device manufacturing method comprising the steps a) to e) as defined in claim 25, **characterized by** the steps of:

- adjusting the measurement of said interferometric displacement measuring means to substantially eliminate the effects of variation in pressure and temperature using a second harmonic interferometric measuring means operating at wavelengths $\lambda_2$ and $\lambda_3$;
- providing purge gas to a space accommodating at least a part of said table to displace therefrom ambient air, wherein said purge gas is substantially non-absorbent of said projection beam of radiation and comprises two or more components, each component having refractivities at the wavelengths $\lambda_1$, $\lambda_2$ and $\lambda_3$ such that the following equation is substantially fulfilled:

$$\frac{\alpha_{m1}}{(\alpha_{m3} - \alpha_{m2})} = K_a \qquad (4)$$

wherein $\alpha_{m1}$ is the refractivity of the purge gas at a wavelength $\lambda_1$, $\alpha_{m2}$ is the refractivity of the purge gas at a wavelength $\lambda_2$, $\alpha_{m3}$ is the refractivity of the purge gas at a wavelength $\lambda_3$ and

$$K_a = \frac{\alpha_{a1}}{(\alpha_{a3} - \alpha_{a2})} \tag{5}$$

wherein $\alpha_{a1}$ is the refractivity index of air at a wavelength $\lambda_1$, $\alpha_{a2}$ is the refractivity index of air at a wavelength $\lambda_2$ and $\alpha_{a3}$ is the refractivity index of air at a wavelength $\lambda_3$.

28. A device manufacturing method comprising the steps a) to d) as defined in claim 25, **characterized by** the steps of:

- providing purge gas to a space accommodating at least a part of a table to displace therefrom ambient air, said table either being suitable for holding said substrate or forming a part of said patterning means, wherein said purge gas is substantially non-absorbent of said projection beam of radiation;
- determining the position of said table using interferometric displacement measuring means operating at a wavelength $\lambda_1$; and
- adjusting the measurement of said interferometric displacement measuring means (DI) using a second harmonic interferometric measuring means operating at wavelengths $\lambda_2$ and $\lambda_3$ according to the following equation:

$$L = (DI) - K(SHI) \tag{9}$$

wherein L is the adjusted interferometric displacement measuring means measurement, SHI is the measurement of the second harmonic interferometric measuring means and K is a coefficient, the value of which is optimized such that the effects of variation in pressure, temperature and purge gas composition are partially eliminated from the adjusted value L.

**Patentansprüche**

1. Eine lithographische Projektionsvorrichtung, aufweisend:

ein Bestrahlungssystem zur Bereitstellung eines Projektionsstrahls einer Strahlung;
Musterungsmittel zum Muster des Projektionsstrahls gemäß einem gewünschten Muster;
einen Substrattisch zum Halten eines Substrates;
ein Projektionssystem zum Abbilden des gemusterten Strahles auf einen Zielabschnitt des Substrats,
**gekennzeichnet durch**:

ein interferometrisches Verschiebungsmessmittel, welches bei einer Wellenlänge $\lambda_1$ zur Messung der Position des Substrattisches oder der Position eines Tisches, der Teil der Musterungsmittel ist, arbeitet;
Spülgasmittel zur Zufuhr von Reinigungsgas in einen Raum, um Umgebungsluft hieraus zu verdrängen, wobei der Raum wenigstens einen Teil des Substrattisches und/oder wenigstens einen Teil des Tisches, der Teil der Musterungsmittel ist, aufnimmt, wobei das Reinigungsgas für den Projektionsstrahl von Strahlung im Wesentlichen nicht-absorbierend ist und einen Brechungsindex bei einer Wellenlänge $\lambda_1$ hat, der im Wesentlichen gleich demjenigen von Luft ist, wenn mit der gleichen Wellenlänge, Temperatur und Druck gemessen wird;
Gaszufuhrmittel mit dem Reinigungsgas.

2. Eine Vorrichtung nach Anspruch 1, wobei das Reinigungsgas zwei oder mehr Bestandteile aufweist, ausgewählt aus $N_2$, He, AR, Kr, Ne und Xe.

3. Eine Vorrichtung nach Anspruch 2, wobei das Reinigungsgas wenigstens 95 Volumenprozent $N_2$ und wenigstens 1 Volumenprozent Xe aufweist.

4. Eine Vorrichtung nach Anspruch 2, wobei das Reinigungsgas wenigstens 95 Volumenprozent Ar und wenigstens 1 Volumenprozent Xe aufweist.

5. Eine Vorrichtung nach Anspruch 2, wobei das Reinigungsgas wenigstens 90 Volumenprozent Ar und wenigstens 5 Volumenprozent Kr aufweist.

6. Eine Vorrichtung nach Anspruch 2, wobei das Reinigungsgas wenigstens 95 Volumenprozent $N_2$ und wenigstens 1 Volumenprozent Ne aufweist.

7. Eine Vorrichtung nach Anspruch 2, wobei das Reinigungsgas wenigstens 50 Volumenprozent $N_2$ und wenigstens 35 Volumenprozent Ar aufweist.

8. Eine Vorrichtung nach Anspruch 2, wobei das Reinigungsgas wenigstens 94 Volumenprozent $N_2$, wenigstens 0,5 Volumenprozent He und wenigstens 0,5 Volumenprozent Xe aufweist.

9. Eine Vorrichtung nach Anspruch 1, welche weiterhin ein zweites harmonisches interferometrisches Messmittel aufweist, welches bei Wellenlängen $\lambda_2$ und $\lambda_3$ arbeitet, um die Messungen des interferometrischen Verschiebungsmessmittels einzujustieren, um Auswirkungen von Änderungen in Druck und Temperatur im Wesentlichen zu beseitigen, und wobei das Reinigungsgas drei oder mehr unterschiedliche Bestandteile aufweist, wobei jeder Bestandteil Brechungswerte an den Wellenlänge $\lambda_2$ und $\lambda_3$ derart hat, dass die folgenden Gleichungen im Wesentlichen erfüllt sind:

$$\sum_{j}^{k} F_j \alpha_{j1} = \alpha_{a1} \qquad (1)$$

$$\sum_{j}^{k} F_j (\alpha_{j3} - \alpha_{j2}) = \alpha_{a3} - \alpha_{a2} \qquad (2)$$

wobei $F_j$ der Volumenbruchteil des Bestandteils j im Reinigungsgas ist, wobei das Reinigungsgas insgesamt k Bestandteile enthält; $\alpha_{j1}$ der Brechungswert des Bestandteils j bei einer Wellenlänge $\lambda_1$ ist; $\alpha_{j2}$ der Brechungswert des Bestandteils j bei einer Wellenlänge $\lambda_2$ ist; $\alpha_{j3}$ der Brechungswert des Bestandteils j bei einer Wellenlänge $\lambda_3$ ist; $\alpha_{a1}$ der Brechungswert von Luft bei einer Wellenlänge $\lambda_2$ ist; und $\alpha_{a3}$ der Brechungswert von Luft bei einer Wellenlänge $\lambda_3$ ist; und wobei

$$\sum_{j}^{k} F_j = 1 \qquad (3)$$

10. Eine Vorrichtung nach Anspruch 9, wobei das Reinigungsgas drei oder mehr unterschiedliche Bestandteile, ausgewählt aus $N_2$, He, Ar, Kr, Ne und Xe aufweist.

11. Eine Vorrichtung nach Anspruch 10, wobei das Reinigungsgas aufweist: (i) $N_2$ und/oder Ar in einer Menge von 50-90 Volumenprozent, (ii) Xe und/oder Kr in einer Menge von 0,5 bis 40 Volumenprozent und (iii) He und/oder Ne in einer Menge von 2 bis 20 Volumenprozent.

12. Eine lithographische Projektionsvorrichtung mit einem Bestrahlungssystem, Musterungsmitteln, einem Substrattisch und einem Projektionssystem nach Anspruch 1, **gekennzeichnet durch**:

    - ein interferometrisches Verschiebungsmessmittel, wie in Anspruch 1 definiert;
    - ein zweites harmonisches interferometrischen Messmittel, welches bei Wellenlängen $\lambda_2$ und $\lambda_3$ zur Einstellung der Messungen des interferometrischen Verschiebungsmessmittels arbeitet, um Auswirkungen von Änderungen in Druck und Temperatur im Wesentlichen zu beseitigen;
    - Spülgasmittel zur Zufuhr von Reinigungsgas in einen Raum, um Umgebungsluft hieraus zu verdrängen, wobei der Raum zumindest einen Teil des Substrattisches und/oder zumindest einen Teil des Tisches aufnimmt, der Teil der Musterungsmittel ist, wobei das Reinigungsgas für den Projektionsstrahl von Strahlung im Wesentlichen nicht absorbierend ist und zwei oder mehr Bestandteile aufweist, wobei jeder Bestandteil Brechungswerte bei

Wellenlängen $\lambda_1$, $\lambda_2$ und $\lambda_3$ derart aufweist, dass die folgende Gleichung im Wesentlichen erfüllt ist:

$$\frac{\alpha_{m1}}{(\alpha_{m3} - \alpha_{m2})} = K_a \qquad (4)$$

wobei $\alpha_{m1}$ der Brechungswert des Reinigungsgases bei einer Wellenlänge $\lambda_1$ ist; $\alpha_{m2}$ der Brechungswert des Reinigungsgases bei einer Wellenlänge $\lambda_2$ ist; $\alpha_{m3}$ der Brechungswert des Reinigungsgases bei einer Wellenlänge $\lambda_3$ ist und

$$K_a = \frac{\alpha_{a1}}{(\alpha_{a3} - \alpha_{a2})} \qquad (5)$$

wobei $\alpha_{m1}$ der Brechungswert von Luft bei einer einer Wellenlänge $\lambda_1$ ist; und $\alpha_{a2}$ und $\alpha_{a3}$ wie in Anspruch 9 definiert sind; und
- Gaszufuhrmittel, welche das Reinigungsgas aufweisen.

13. Eine Vorrichtung nach Anspruch 12, wobei das Reinigungsgas zwei oder mehr Gase, ausgewählt aus $N_2$, He, Ar, Kr, Ne und Xe aufweist.

14. Eine Vorrichtung nach Anspruch 13, wobei das Reinigungsgas aufweist: (i) $N_2$, He, Ar und/oder Ne in einer Menge von 65 bis 99,5 Volumenprozent und (ii) Kr und/oder Xe in einer Menge von 0,5 bis 35 Volumenprozent.

15. Eine lithographische Projektionsvorrichtung mit einem Bestrahlungssystem, Musterungsmitteln, einem Substrattisch und einem Projektionssystem, wie in Anspruch 1 definiert, **gekennzeichnet durch**:

- Spülgasmittel zur Zufuhr von Reinigungsgas in einen Raum, um Umgebungsluft hieraus zu verdrängen, wobei der Raum wenigstens einen Teil des Substrattisches und/oder wenigstens einen Teil des Tisches aufnimmt, der Teil der Musterungsmittel ist, wobei das Reinigungsgas für den Projektionsstrahl der Strahlung im Wesentlichen nicht absorbierend ist;
- ein interferometrisches Verschiebungsmessmittel, wie in Anspruch 1 definiert; und
- ein zweites harmonisches interferometrisches Messmittel, welches bei Wellenlängen $\lambda_2$ und $\lambda_3$ arbeitet, um die Messungen des interferometrischen Verschiebungsmessmittels (DI) gemäß der folgenden Gleichung einzustellen:

$$L = (DI) - K(SHI) \qquad (9)$$

wobei L die eingestellte Messung des interferometrischen Verschiebungsmessmittels ist, SHI die Messung des zweiten harmonischen interferometrischen Messmittels ist und K ein Koeffizient ist, dessen Wert so optimiert ist, dass Effekte von Änderungen in Druck, Temperatur und Reinigungsgaszusammensetzung teilweise aus der eingestellten Messung L teilweise beseitigt sind.

16. Eine Vorrichtung nach Anspruch 15, wobei das Reinigungsgas einen Brechungsindex bei einer Wellenlänge $\lambda_1$ hat, der im Wesentlichen gleich demjenigen von Luft ist, gemessen bei der gleichen Wellenlänge, Temperatur und Druck.

17. Eine Vorrichtung nach Anspruch 15 oder 16, wobei K gegeben ist durch die Gleichung:

$$K = \frac{(\alpha_{c3} - \alpha_{c2})(\alpha_{c1})\left(\dfrac{\sigma_\rho}{\rho_0}\right)^2 + (\alpha_{m1} - \alpha_{a1})(\alpha_{m3} - \alpha_{m2} - \alpha_{a3} + \alpha_{a2})\sigma_C^2}{(\alpha_{c3} - \alpha_{c2})^2\left(\dfrac{\sigma_\rho}{\rho_0}\right)^2 + (\alpha_{m3} - \alpha_{m2} - \alpha_{a1} + \alpha_{a2})^2\sigma_C^2} \qquad (22)$$

wobei $\alpha_{mx}$ und $\alpha_{ax}$ den Brechungswert des Reinigungsgases bzw. Luft bei einer Wellenlänge $\lambda_x$ darstellen und $\alpha_{cx}$ den Brechungswert von Luft darstellt, welche mit einer relativen Menge c des Reinigungsgases bei einer Wellenlänge $\lambda_x$ kontaminiert ist, $\rho$ einen Quotientenausdruck, dividiert durch die Absoluttemperatur darstellt, $\sigma_\rho$ die Standardabweichung von $\rho$ ist und $\sigma_c$ die Standardabweichung von c ist.

**18.** Eine Vorrichtung nach einem der Ansprüche 15-17, wobei das Reinigungsgas wenigstens 95 Volumenprozent He aufweist.

**19.** Eine Vorrichtung nach einem der Ansprüche 15 bis 17, wobei das Reinigungsgas von 94 bis 96 Volumenprozent $N_2$ und von 4 bis 6 Volumenprozent He aufweist.

**20.** Eine Vorrichtung nach einem der vorhergehenden Ansprüche, wobei $\lambda_1$ ungefähr 633 nm beträgt, $\lambda_2$ ungefähr 532 nm beträgt und $\lambda_3$ ungefähr 266 nm beträgt.

**21.** Eine Vorrichtung nach einem der vorhergehenden Ansprüche, wobei die Spülgasmittel eine Zufuhr von Reinigungsgas, wie in einem der vorhergehenden Ansprüche definiert, einen Gasströmungsregulator zur Steuerung der Strömungsrate des Reinigungsgases in den Raum und Absaugmittel zur Entfernung des Reinigungsgases aus dem Raum aufweist.

**22.** Eine Vorrichtung nach Anspruch 21, wobei der Strömungsregulator einen Strömungsbegrenzer aufweist.

**23.** Eine Vorrichtung nach Anspruch 21 oder 22, wobei der Strömungsregulator ein Gebläse aufweist.

**24.** Eine Vorrichtung nach einem der vorhergehenden Ansprüche, wobei die Strahlung des Projektionsstrahls eine Wellenlänge von weniger als ungefähr 180 nm, bevorzugt von ungefähr 157 nm oder 126 nm hat.

**25.** Ein Vorrichtungsherstellungsverfahren, aufweisend die Schritte von:

a) Bereitstellen eines Substrats, welches wenigstens teilweise mit einer Schicht aus strahlungsempfindlichen Material bedeckt ist;
b) Bereitstellen eines Projektionsstrahls einer Strahlung unter Verwendung eines Bestrahlungssystems;
c) Verwendung von Musterungsmitteln, um dem Projektionsstrahl in seinem Querschnitt mit einem Muster zu versehen;
d) Projizieren des gemusterten Strahls der Strahlung auf einen Zielbereich der Schicht aus strahlungsempfindlichen Material;
e) Bestimmen der Position eines Tisches unter Verwendung interferometrischer Verschiebungsmessmittel, die bei einer Wellenlänge $\lambda_1$ arbeiten, wobei der Tisch entweder geeignet ist zum Halten des Substrates oder einen Teil der Musterungsmittel bildet;

**gekennzeichnet durch** den Schritt von

- Liefern von Reinigungsgas in einen Raum, der wenigstens einen Teil des Tisches aufnimmt, um Umgebungsluft hieraus zu verdrängen, wobei das Reinigungsgas für den Projektionsstrahl der Strahlung im Wesentlichen nicht absorbierend ist und bei einer Wellenlänge $\lambda_1$ einen Brechungsindex hat, der im Wesentlichen der gleiche wie derjenige von Luft, gemessen bei der gleichen Wellenlänge, Temperatur und Druck ist.

**26.** Ein Verfahren nach Anspruch 25, welches weiterhin den Schritt der Einjustierung der Messung des interferometrischen Verschiebungsmessmittels aufweist, um Auswirkungen von Schwankungen in Druck und Temperatur im Wesentlichen zu beseitigen, wobei ein zweites harmonisches interferometrisches Messmittel verwendet wird, wel-

ches bei Wellenlängen $\lambda_2$ und $\lambda_3$ arbeitet; und wobei das Reinigungsgas drei oder mehr unterschiedliche Bestandteile aufweist, wobei jeder Bestandteil bei den Wellenlängen $\lambda_2$ und $\lambda_3$ Brechungswerte derart hat, dass die folgenden Gleichungen im Wesentlichen erfüllt sind:

$$\sum_{j}^{k} F_j \alpha_{j1} = \dot{\alpha}_{a1} \qquad\qquad (1)$$

$$\sum_{j}^{k} F_j (\alpha_{j3} - \alpha_{j2}) = \alpha_{a3} - \alpha_{a2} \qquad\qquad (2)$$

wobei $F_j$ ein Volumenbruchteil des Bestandteils j in dem Reinigungsgas ist, wobei das Reinigungsgas eine Gesamtzahl von k Bestandteilen enthält; $\alpha_{j1}$ der Brechungswert des Bestandteils j bei einer Wellenlänge $\lambda_1$ ist; $\alpha_{j2}$ der Brechungswert des Bestandteils j bei einer Wellenlänge $\lambda_2$ ist; $\alpha_{j3}$ der Brechungswert des Bestandteils j bei einer Wellenlänge $\lambda_3$ ist; $\alpha_{a1}$ der Brechungswert von Luft bei einer Wellenlänge $\lambda_1$ ist; $\alpha_{a2}$ der Brechungswert von Luft bei einer Wellenlänge $\lambda_2$ ist; und $\alpha_{a3}$ der Brechungswert von Luft bei einer Wellenlänge $\lambda_3$ ist, und wobei:

$$\sum_{j}^{k} F_j = 1 \qquad\qquad (3)$$

27. Ein Vorrichtungsherstellungsverfahren mit den Schritten a) bis e), wie in Anspruch 25 definiert, **gekennzeichnet durch** die Schritte von:

   - Einjustieren der Messung des interferometrischen Verschiebungsmessmittels, um die Auswirkungen von Änderungen in Druck und Temperatur im Wesentlichen zu beseitigen, wobei ein zweites harmonisches interferometrisches Messmittel verwendet wird, welches bei Wellenlängen $\lambda_2$ und $\lambda_2$ arbeitet;
   - Liefern von Reinigungsgas in einen Raum, der wenigstens einen Teil des Tisches aufweist, um Umgebungsluft hieraus zu verdrängen, wobei das Reinigungsgas für den Projektionsstrahl der Strahlung im Wesentlichen nicht absorbierend ist und zwei oder mehr Bestandteile aufweist, wobei jeder Bestandteil Brechungswerte an den Wellenlängen $\lambda_1$, $\lambda_2$ und $\lambda_3$ derart aufweist, dass die folgende Gleichung im Wesentlichen erfüllt ist:

$$\frac{\alpha_{m1}}{(\alpha_{m3} - \alpha_{m2})} = K_a \qquad\qquad (4)$$

wobei $\alpha_{m1}$ der Brechungswert des Reinigungsgases bei einer Wellenlänge $\lambda_1$ ist; $\alpha_{m2}$ der Brechungswert des Reinigungsgases bei einer Wellenlänge $\lambda_2$ ist; $\alpha_{m3}$ der Brechungswert des Reinigungsgases bei einer Wellenlänge $\lambda_3$ ist; und

$$K_a = \frac{\alpha_{a1}}{(\alpha_{a3} - \alpha_{a2})} \qquad\qquad (5)$$

wobei $\alpha_{a1}$ der Brechungsindex von Luft bei einer Wellenlänge $\lambda_1$ ist; $\alpha_{a2}$ der Brechungsindex von Luft bei einer Wellenlänge $\lambda_2$ ist; und $\alpha_{a3}$ der Brechungsindex von Luft bei einer Wellenlänge $\lambda_3$ ist.

28. Ein Vorrichtungsherstellungsverfahren mit den Schritten a) bis d), wie in Anspruch 25 definiert, **gekennzeichnet durch** die Schritte von:

   - Liefern von Reinigungsgas in einen Raum, der wenigstens einen Teil eines Tisches aufnimmt, um Umgebungsluft hieraus zu verdrängen, wobei der Tisch entweder geeignet ist zum Halten des Substrates oder einen Teil des Musterungsmittels bildet, wobei das Reinigungsgas für den Projektionsstrahl von der Strahlung im Wesentlichen nicht absorbierend ist;

- Bestimmen der Position des Tisches unter Verwendung eines interferometrischen Verschiebungsmessmittels, das bei einer Wellenlänge $\lambda_1$ arbeitet; und

- Einjustieren der Messung des interferometrischen Verschiebungsmessmittels (DI) unter Verwendung eines zweiten harmonischen interferometrischen Messmittels, das bei Wellenlängen $\lambda_2$ und $\lambda_3$ arbeitet, gemäß der folgenden Gleichung:

$$L = (DI) - K(SHI) \qquad (9)$$

wobei L die eingestellte Messung des interferometrischen Verschiebungsmessmittels ist, SHI die Messung des zweiten harmonischen interferometrischen Messmittels ist und K ein Koeffizient ist, dessen Wert so optimiert ist, dass die Auswirkungen von Änderungen in Druck, Temperatur und Reinigungsgaszusammensetzung aus dem eingestellten Wert L teilweise beseitigt sind.

**Revendications**

1. Appareil de projection lithographique comportant :

- un système de rayonnement pour délivrer un faisceau de projection de rayonnement ;
- des moyens de formation de motif pour munir d'un motif le faisceau de projection conformément à un motif voulu ;
- une table de substrat pour porter un substrat ;
- un système de projection pour reproduire le faisceau muni d'un motif sur une partie cible du substrat,

**caractérisé par** :

- des moyens de mesure de déplacement interférométriques fonctionnant à une longueur d'onde $\lambda_1$ pour mesurer la position de ladite table de substrat ou la position d'une table qui est une partie desdits moyens de formation de motif ;
- des moyens de gaz de rinçage pour fournir un gaz de purge à un espace, pour déplacer de celui-ci de l'air ambiant, ledit espace recevant au moins une partie de ladite table de substrat et/ou au moins une partie de ladite table qui est une partie desdits moyens de formation de motif, dans lesquels ledit gaz de purge est sensiblement non-absorbant vis-à-vis dudit faisceau de projection de rayonnement et a un indice de réfraction à une longueur d'onde $\lambda_1$ qui est sensiblement le même que celui de l'air mesuré aux mêmes longueur d'onde, température et pression ; et
- des moyens de fourniture de gaz comportant ledit gaz de purge.

2. Appareil selon la revendication 1, dans lequel le gaz de purge comporte deux composants ou plus sélectionnés parmi $N_2$, He, Ar, Kr, Ne et Xe.

3. Appareil selon la revendication 2, dans lequel ledit gaz de purge comporte au moins 95 % en volume de $N_2$ et au moins 1 % en volume de He.

4. Appareil selon la revendication 2, dans lequel ledit gaz de purge comporte au moins 95 % en volume de Ar et au moins 1 % en volume de Xe.

5. Appareil selon la revendication 2, dans lequel ledit gaz de purge comporte au moins 90 % en volume de Ar et au moins 5 % en volume de Kr.

6. Appareil selon la revendication 2, dans lequel ledit gaz de purge comporte au moins 95 % en volume de $N_2$ et au moins 1 % en volume de Ne.

7. Appareil selon la revendication 2, dans lequel ledit gaz de purge comporte au moins 50 % en volume de $N_2$ et au

moins 35 % en volume de Ar.

**8.** Appareil selon la revendication 2, dans lequel ledit gaz de purge comporte au moins 94 % en volume de $N_2$, au moins 0,5 % en volume de He et au moins 0,5 % en volume de Xe.

**9.** Appareil selon la revendication 1, qui comporte de plus des deuxièmes moyens de mesure interférométriques harmoniques fonctionnant à des longueurs d'onde $\lambda_2$ et $\lambda_3$ pour ajuster les mesures desdits moyens de mesure de déplacement interférométriques pour éliminer sensiblement les effets de variation de pression et de température, et dans lequel ledit gaz de purge comporte trois composants différents ou plus, chaque composant ayant des réfractivités aux longueurs d'onde $\lambda_2$ et $\lambda_3$ telles que les équations suivantes sont sensiblement satisfaites :

$$\sum_{j}^{k} F_j \alpha_{j1} = \alpha_{a1} \qquad (1)$$

$$\sum_{j}^{k} F_j (\alpha_{j3} - \alpha_{j2}) = \alpha_{a3} - \alpha_{a2} \qquad (2)$$

où $F_j$ est la fraction en volume d'un composant j dans le gaz de purge, lequel gaz de purge contient un total de k composants, $\alpha_{j1}$ est la réfractivité du composant j à une longueur d'onde $\lambda_1$, $\alpha_{j2}$ est la réfractivité du composant j à une longueur d'onde $\lambda_2$, $\alpha_{j3}$ est la réfractivité d'un composant j à une longueur d'onde $\lambda_3$, $\alpha_{a1}$ est la réfractivité de l'air à une longueur d'onde $\lambda_1$, $\alpha_{a2}$ est la réfractivité de l'air à une longueur d'onde $\lambda_2$, et $\alpha_{a3}$ est la réfractivité de l'air à une longueur d'onde $\lambda_3$ ; et où :

$$\sum_{j}^{k} F_j = 1 \qquad (3)$$

**10.** Appareil selon la revendication 9, dans lequel ledit gaz de purge comporte trois composants différents ou plus sélectionnés parmi $N_2$, He, Ar, Kr, Ne et Xe.

**11.** Appareil selon la revendication 10, dans lequel ledit gaz de purge comporte (i) $N_2$ et/ou Ar en une quantité de 50 à 90 % en volume, (ii) Xe et/ou Kr en une quantité de 0,5 à 40 % en volume, et (iii) He et/ou Ne en une quantité de 2 à 20 % en volume.

**12.** Appareil de projection lithographique comportant un système de rayonnement, des moyens de formation de motif, une table de substrat et un système de projection comme définis dans la revendication 1,
**caractérisé par** :

- des moyens de mesure de déplacement interférométriques comme définis dans la revendication 1 ;
- des deuxièmes moyens de mesure interférométriques harmoniques fonctionnant à des longueurs d'onde $\lambda_2$ et $\lambda_3$ pour ajuster les mesures desdits moyens de mesure de déplacement interférométriques pour éliminer sensiblement les effets de variation de pression et de température ;
- des moyens de gaz de rinçage pour fournir un gaz de purge dans un espace, pour déplacer de celui-ci de l'air ambiant, ledit espace recevant au moins une partie de ladite table de substrat et/ou au moins une partie de ladite table qui est une partie desdits moyens de formation de motif, dans lesquels ledit gaz de purge est essentiellement non-absorbant vis-à-vis dudit faisceau de projection de rayonnement et comporte deux composants ou plus, chaque composant ayant des réfractivités aux longueurs d'onde $\lambda_1$, $\lambda_2$ et $\lambda_3$ telles que l'équation suivante est sensiblement satisfaite :

$$\frac{\alpha_{m1}}{(\alpha_{m3} - \alpha_{m2})} = K_a \qquad (4)$$

où $\alpha_{m1}$ est la réfractivité du gaz de purge à une longueur d'onde $\lambda_1$, $\alpha_{m2}$ est la réfractivité du gaz de purge à une longueur d'onde $\lambda_2$, $\alpha_{m3}$ est la réfractivité du gaz de purge à une longueur d'onde $\lambda_3$ et

$$K_a = \frac{\alpha_{a1}}{(\alpha_{a3} - \alpha_{a2})} \qquad (5)$$

où $\alpha_{a1}$ est la réfractivité de l'air à une longueur d'onde $\lambda_1$ et $\alpha_{a2}$ et $\alpha_{a3}$ sont comme défini dans la revendication 9 ; et
- des moyens de fourniture de gaz comportant ledit gaz de purge.

13. Appareil selon la revendication 12, dans lequel ledit gaz de purge comporte deux gaz ou plus sélectionnés parmi $N_2$, He, Ar, Kr, Ne et Xe.

14. Appareil selon la revendication 13, dans lequel ledit gaz de purge comporte (i) $N_2$, He, Ar et/ou Ne en une quantité de 65 à 99,5 % en volume et (ii) Kr et/ou Xe en une quantité de 0,5 à 35 % en volume.

15. Appareil de projection lithographique comportant un système de rayonnement, des moyens de formation de motif, une table de substrat et un système de projection comme définis dans la revendication 1,
**caractérisé par** :

- des moyens de gaz de rinçage pour fournir un gaz de purge à un espace, pour déplacer de celui-ci de l'air ambiant, ledit espace recevant au moins une partie de ladite table de substrat et/ou au moins une partie de ladite table qui est une partie desdits moyens de formation de motif, dans lesquels ledit gaz de purge est essentiellement non-absorbant vis-à-vis dudit faisceau de projection de rayonnement ;
- des moyens de mesure de déplacement interférométriques comme définis dans la revendication 1 ; et
- des deuxièmes moyens de mesure interférométriques harmoniques fonctionnant à des longueurs d'onde $\lambda_2$ et $\lambda_3$ pour ajuster les mesures desdites moyens de mesure de déplacement interférométriques (DI) conformément à l'équation suivante :

$$L = (DI) - K(SHI) \qquad (9)$$

où L est la mesure ajustée des moyens de mesure de déplacement interférométriques, SHI est la mesure des deuxièmes moyens de mesure interférométriques harmoniques et K est un coefficient, dont la valeur est optimisée de sorte que les effets de variation de pression, de température et de composition de gaz de purge sont partiellement éliminés de la mesure ajustée L.

16. Appareil selon la revendication 15, dans lequel ledit gaz de purge a un indice de réfraction à une longueur d'onde $\lambda_1$ qui est essentiellement le même que celui de l'air mesuré aux mêmes longueur d'onde, température et pression.

17. Appareil selon la revendication 15 ou 16, dans lequel K est donné par l'équation suivante :

$$K = \frac{(\alpha_{c3} - \alpha_{c2})(\alpha_{c1})\left(\dfrac{\sigma_\rho}{\rho_0}\right)^2 + (\alpha_{m1} - \alpha_{a1})(\alpha_{m3} - \alpha_{m2} - \alpha_{a3} + \alpha_{a2})\sigma_C^2}{(\alpha_{c3} - \alpha_{c2})^2\left(\dfrac{\sigma_\rho}{\rho_0}\right)^2 + (\alpha_{m3} - \alpha_{m2} - \alpha_{a3} + \alpha_{a2})^2\sigma_C^2} \qquad (22)$$

où $\alpha_{mx}$ et $\alpha_{ax}$ représentent la réfractivité du gaz de purge ou de l'air respectivement à une longueur d'onde $\lambda_x$ et $\alpha_{cx}$ représentent la réfractivité de l'air contaminé par une quantité relative c du gaz de purge à une longueur d'onde $\lambda_x$, $\rho$ représente le quotient pression divisée par température absolue, $\sigma_\rho$ est l'écart type de $\rho$ et $\sigma_c$ est l'écart type de c.

**18.** Appareil selon l'une quelconque des revendications 15 à 17, dans lequel le gaz de purge comporte au moins 95 % en volume de He.

**19.** Appareil selon l'une quelconque des revendications 15 à 17, dans lequel le gaz de purge comporte de 94 à 96 % en volume de $N_2$ et de 4 à 6 % en volume de He.

**20.** Appareil selon l'une quelconque des revendications précédentes dans lequel $\lambda_1$ est environ 633 nm, $\lambda_2$ est environ 532 nm et $\lambda_3$ est environ 266 nm.

**21.** Appareil selon l'une quelconque des revendications précédentes, dans lequel lesdits moyens de gaz de rinçage comportent une fourniture de gaz de purge comme définie dans l'une quelconque des revendications précédentes, un régulateur d'écoulement de gaz pour commander la vitesse d'écoulement du gaz de purge dans ledit espace et des moyens d'évacuation pour retirer le gaz de purge dudit espace.

**22.** Appareil selon la revendication 21, dans lequel ledit régulateur d'écoulement comporte un limiteur de débit.

**23.** Appareil selon la revendication 21 ou 22, dans lequel ledit régulateur d'écoulement comporte une soufflante.

**24.** Appareil selon l'une quelconque des revendications précédentes, dans lequel ledit rayonnement dudit faisceau de projection a une longueur d'onde inférieure à environ 180 nm, de préférence d'environ 157 nm ou 126 nm.

**25.** Procédé de production de dispositif comportant les étapes consistant à:

a) prévoir un substrat qui est au moins partiellement recouvert d'une couche de matériau sensible au rayonnement ;
b) prévoir un faisceau de projection de rayonnement en utilisant un système de rayonnement ;
c) utiliser des moyens de formation de motif pour doter le faisceau de projection d'un motif dans sa section transversale ;
d) projeter le faisceau de rayonnement muni d'un motif sur une zone cible de la couche de matériau sensible au rayonnement,
e) déterminer la position d'une table en utilisant des moyens de mesure de déplacement interférométriques fonctionnant à une longueur d'onde $\lambda_1$, ladite table soit étant adaptée pour porter ledit substrat soit formant une partie desdits moyens de formation de motif ;

**caractérisé par** l'étape consistant à

- fournir un gaz de purge à un espace recevant au moins une partie de ladite table pour déplacer de celui-ci de l'air ambiant, ledit gaz de purge étant essentiellement non-absorbant vis-à-vis dudit faisceau de projection de rayonnement et ayant un indice de réfraction à une longueur d'onde $\lambda_1$ qui est sensiblement le même que celui de l'air mesuré aux mêmes longueur d'onde, température et pression.

**26.** Procédé selon la revendication 25, qui comporte de plus l'étape consistant à ajuster la mesure desdits moyens de mesure de déplacement interférométriques pour éliminer sensiblement les effets de variation de pression et de température en utilisant des deuxièmes moyens de mesure interférométriques harmoniques fonctionnant à des longueurs d'onde $\lambda_2$ et $\lambda_3$ ; et dans lequel ledit gaz de purge comporte trois composants différents ou plus, chaque composant ayant des réfractivités aux longueurs d'onde $\lambda_2$ et $\lambda_3$ telles que les équations suivantes sont sensiblement satisfaites :

$$\sum_{j}^{k} F_j \alpha_{j1} = \alpha_{a1} \tag{1}$$

$$\sum_{j}^{k} F_j (\alpha_{j3} - \alpha_{j2}) = \alpha_{a3} - \alpha_{a2} \tag{2}$$

où $F_j$ est la fraction en volume d'un composant j dans le gaz de purge, lequel gaz de purge contient un total de k composants, $\alpha_{j1}$ est la réfractivité du composant j à une longueur d'onde $\lambda_1$, $\alpha_{j2}$ est la réfractivité du composant j à une longueur d'onde $\lambda_2$, $\alpha_{j3}$ est la réfractivité du composant j à une longueur d'onde $\lambda_3$, $\alpha_{a1}$ est la réfractivité de l'air à une longueur d'onde $\lambda_1$, $\alpha_{a2}$ est la réfractivité de l'air à une longueur d'onde $\lambda_2$, et $\alpha_{a3}$ est la réfractivité de l'air à une longueur d'onde $\lambda_3$ ; et où :

$$\sum_{j}^{k} F_j = 1 \qquad (3)$$

27. Procédé de production de dispositif comportant les étapes a) à e) comme définies dans la revendication 25, **caractérisé par** les étapes consistant à :

> - ajuster la mesure desdites moyens de mesure de déplacement interférométriques pour éliminer sensiblement les effets de variation de température et de pression en utilisant des deuxièmes moyens de mesure interférométriques harmoniques fonctionnant à des longueurs d'onde $\lambda_2$ et $\lambda_3$ ;
> - fournir un gaz de purge à un espace recevant au moins une partie de ladite table pour déplacer de celui-ci de l'air ambiant, dans lequel le gaz de purge est essentiellement non-absorbant vis-à-vis dudit faisceau de projection de rayonnement et comporte deux composants ou plus, chaque composant ayant des réfractivités aux longueurs d'onde $\lambda_1$, $\lambda_2$ et $\lambda_3$ telles que l'équation suivante est sensiblement satisfaite :

$$\frac{\alpha_{m1}}{(\alpha_{m3} - \alpha_{m2})} = K_a \qquad (4)$$

où $\alpha_{m1}$ est la réfractivité du gaz de purge à une longueur d'onde $\lambda_1$, $\alpha_{m2}$ est la réfractivité du gaz de purge à une longueur d'onde $\lambda_2$, $\alpha_{m3}$ est la réfractivité du gaz de purge à une longueur d'onde $\lambda_3$ et

$$K_a = \frac{\alpha_{a1}}{(\alpha_{a3} - \alpha_{a2})} \qquad (5)$$

où $\alpha_{a1}$ est l'indice de réfractivité de l'air à une longueur d'onde $\lambda_1$, $\alpha_{a2}$ est l'indice de réfractivité de l'air à une longueur d'onde $\lambda_2$ et $\alpha_{a3}$ est l'indice de réfractivité de l'air à une longueur d'onde $\lambda_3$.

28. Procédé de production de dispositif comportant les étapes a) à d) comme définies dans la revendication 25, **caractérisé par** les étapes consistant à :

> - fournir un gaz de purge à un espace recevant au moins une partie d'une table pour déplacer de celui-ci de l'air ambiant, ladite table soit étant adaptée pour porter ledit substrat soit formant une partie desdits moyens de formation de motif, dans lequel ledit gaz de purge est essentiellement non-absorbant vis-à-vis dudit faisceau de projection de rayonnement ;
> - déterminer la position de ladite table en utilisant des moyens de mesure de déplacement interférométriques fonctionnant à une longueur d'onde $\lambda_1$ ; et
> - ajuster la mesure desdits moyens de mesure de déplacement interférométriques (DI) en utilisant des deuxièmes moyens de mesure interférométriques harmoniques fonctionnant à des longueurs d'onde $\lambda_2$ et $\lambda_3$ conformément à l'équation suivante :

$$L = (DI) - K(SHI) \qquad (9)$$

où L est la mesure ajustée des moyens de mesure de déplacement interférométriques, SHI est la mesure des deuxièmes moyens de mesure interférométriques harmoniques et K est un coefficient, dont la valeur est optimisée de sorte que les effets de variation de pression, de température et de composition de gaz de purge sont partiellement éliminés de la mesure ajustée L.

# Fig.1.

## Fig.2.

## Fig.3.